# EUROPÄISCHE PATENTSCHRIFT

(11) **EP 2 414 567 B1**
(45) Veröffentlichungstag und Bekanntmachung des Hinweises auf die Patenterteilung: **20.11.2013**
(21) Anmeldenummer: 11709883.0
(22) Anmeldetag: 18.03.2011
(51) Int. Cl.: C30B 23/02, C30B 23/04, C30B 25/02, C30B 25/04, C30B 25/18

(54) **SEMIPOLARER HALBLEITERKRISTALL UND VERFAHREN ZUR HERSTELLUNG DESSELBEN**
SEMIPOLAR SEMICONDUCTOR AND ITS METHOD OF PRODUCTION
SEMI-CONDUCTEUR SEMI-POLAIRE ET PROCEDE DE FABRICATION DE CELUI-CI

(30) Priorität: 18.03.2010 DE 102010011895
(43) Veröffentlichungstag der Anmeldung: 08.02.2012
(73) Patentinhaber: Freiberger Compound Materials GmbH, 09599 Freiberg (DE)
(72) Erfinder: WUNDERER, Thomas, 87448 Waltenhofen (DE); SCHWAIGER, Stephan, 89081 Ulm (DE); SCHWAIGER, Ilona, 89081 Ulm (DE); RÖSCH, Rudolph, 89335 Ichenhausen (DE); LIPSKI, Frank, 89231 Neu-Ulm (DE); SCHOLZ, Ferdinand, 89075 Ulm (DE)
(74) Vertreter: Prüfer & Partner GbR European Patent Attorneys
(86) Internationale Anmeldenummer: PCT/EP2011/001339
(87) Internationale Veröffentlichungsnummer: WO 2011/113605

(56) Entgegenhaltungen:
- OKADA N ET AL: "Growth of Semipolar (11-22) GaN Layer by Controlling Anisotropic Growth Rates in r-Plane Patterned Sapphire Substrate", APPLIED PHYSICS EXPRESS 2, INSTITUTE OF PURE AND APPLIED PHYSICS, JP, Bd. 2, Nr. 9, 28. August 2009 (2009-08-28) , Seiten 91001-1-091001-3, XP001549718, ISSN: 1882-0778, DOI: 10.1143/APEX.2.091001 in der Anmeldung erwähnt
- WEI T B, HU Q, DUAN R F, WEI X C, HUO Z Q, WANG J X, ZENG Y P, WANG G H, LI J M: "Growth of (1 0-1-3 ) semipolar GaN on m-plane sapphire by hydride vapor phase epitaxy", JOURNAL OF CRYSTAL GROWTH, Bd. 311, 9. Juli 2009 (2009-07-09), Seiten 4153-4157, XP002632731, DOI: 10.1016/j.jcrysgro.2009.06.058
- ZHOU L, CHANDRASEKARAN R, MOUSTAKAS T D, SMITH D J: "Structural characterization of non-polar (11-20) and semi-polar (11-26) GaN films grown on r-plane sapphire", JOURNAL OF CRYSTAL GROWTH, Bd. 310, 12. März 2008 (2008-03-12), Seiten 2981-2986, XP002632732, DOI: 10.1016/j.jcrysgro.2008.03.013
- OKADA N, KAWASHIMA Y, TADATOMO K: "Direct Growth of m-plane GaN with Epitaxial Lateral Overgrowth from c-plane Sidewall of a-plane Sapphire", APPLIED PHYSICS EXPRESS 1, 31. Oktober 2008 (2008-10-31), Seiten 111101-1-111101-3, XP002632733, DOI: 10.1143/APEX.1.111101 in der Anmeldung erwähnt

## Beschreibung

Die Erfindung betrifft einen ein Gruppe-III-Nitrid (III-N) umfassenden, semipolaren Halbleiterkristall sowie ein Verfahren zur Herstellung desselben. Die Erfindung betrifft insbesondere auch einen semipolaren Galliumnitrid-(Ga,Al,In)N-Kristall sowie die Kombination eines solchen Kristalls mit einem Saphir (Al₂O₃) als Startsubstrat für einen Aufwachsprozess.

Halbleitermaterialien, die aus Gruppe-III-Gruppe-V-Verbindungen gebildet werden, kommen unter anderem aufgrund ihrer Eigenschaft, Licht in einem breiten Wellenlängenbereich auszustrahlen, vor allem in lichtemittierenden Dioden (LEDs) zum Einsatz. Mit "III" und "V" werden im folgenden Elemente der betreffenden Haupt-Gruppe des Periodensystems der chemischen Elemente bezeichnet. Insbesondere haben sich Gruppe-III-Nitridverbindungen für den grünen bis ultravioletten Wellenlängenbereich als besonders geeignet erwiesen, darunter GaN (Galliumnitrid), InGaN (Indiumgalliumnitrid), AlGaN (Aluminiumgalliumnitrid) und AlGaInN (Aluminiumgalliumindiumnitrid).

Die letztgenannten Verbindungen werden üblicherweise durch metallorganische Gasphasenepitaxie (MOVPE), Hydridgasphasenepitaxie (HVPE) oder Molekularstrahlepitaxie (MBE) etc. auf einem Startsubstrat aufgewachsen, um einen Einkristall herzustellen. Leider liegen als Startsubstrate derzeit noch nicht entsprechend große GaN-Einkristalle vor. Es muss daher auf Fremdsubstrate ausgewichen werden, wobei solche Materialien mit annähernd passendem Kristallsystem verwendet werden. Für Galliumnitrid sind dies vor allem Saphir (Al₂O₃) oder Siliziumcarbid (SiC). Zur Bildung der Endprodukte sind dann diese Ausgangs- oder Startsubstrate auf chemischem oder mechanischem Wege vom GaN-Einkristall etc. zu entfernen.

Galliumnitrid (womit im folgenden auch seine ternären oder quaternären Verbindungen umfasst sein sollen) besitzt ein hexagonales Wurtzit-Gitter und hat damit eine ähnliche Kristallstruktur wie Saphir, welches ein trigonales Korundgitter aufweist. Das Kristallwachstum wird gegenwärtig bei der Epitaxie allgemein entlang der c-Achse [0001], d.h. senkrecht zur c-Ebene (0001) durchgeführt, welche die Symmetrieachse der Hexagonalstruktur ist. Die Oberfläche des als Startsubstrat bereitgestellten Saphirsubstrats (Wafer), auf welcher der Aufwachsprozess beginnt, wird daher auch durch die entsprechende c-Ebene gebildet. Die c-Ebene (0001) charakterisiert folglich auch den fertigen GaN-Kristall, so wie er dann auch in LEDs verwendet wird.

Aufgrund des polaren Aufbaus des Kristalls entlang der c-Achse [0001] kann es im Zusammenspiel mit der Kristallgeometrie allerdings beim GaN zum Aufbau nicht unerheblicher piezoelektrischer Felder kommen. Entlang der c-Achse ist damit eine Bandverschiebung feststellbar, aus welcher der sog. *Quantum Confined Stark Effect* (QCSE) resultiert. Die Wellenfunktionen von Elektronen und Löchern der in dieser Richtung durch alternierende Schichtfolgen eingerichteten Quantentöpfe (*Quantum Wells,* QW) trennen sich dabei räumlich, welches zu einer verminderten Rekombinationsrate der Elektronen und Löcher in der LEDs führt etc.

Die c-Ebene als Oberfläche des GaN-Einkristalls wird folglich als "polar" bezeichnet. Im Gegensatz dazu sind aber die zur c-Ebene senkrechten m-Ebenen {1-100} oder a-Ebenen {11-20} im GaN-Einkristall unpolar, da hier Ga- und N-Atome in derselben Ebene liegen. Es wurden daher viele Versuche unternommen, GaN-Einkristalle mit entsprechend an den m- oder a-Ebenen ausgerichteten Oberflächen herzustellen.

Da wie beschrieben Fremdsubstrate als Ausgangspunkt zu verwenden sind, ergibt sich aber gerade in jenen Fällen verstärkt das Problem, dass Stapelfehler usw. auftreten können.

Gleichwohl wird in Okada, N. et al.: "Direct Growth of m-plane GaN with Epitaxial Lateral Overgrowth from c-plane Sidewall of a-plane Sapphire ", Appl.Phys.Expr. 1 (2008), page 111101 berichte, dass unpolares GaN (m-Ebene) bzw. {1-100} mittels MOVPE auf einem Saphirsubstrat mit {11-20}-Ausrichtung (a-Ebene) aufgewachsen werden konnte.

Dazu wurden durch reaktives Ionenätzen (RIE, *reactive ion etching*) Gräben mit diese trennenden Stegen im Saphirsubstrat eingebracht. Seitliche Facetten der Stege besaßen eine Neigung von 68 bzw. 79 Grad gegenüber der Horizontalen. Die Oberseite der Stege wurde durch eine 200 nm dicke SiO₂-Schicht maskiert, um dort ein Aufwachsen von GaN zu verhindern. Die Stegoberseiten waren 4 µm breit, die Gräben 2 µm. Die Grundfläche des Grabens war aufgrund der geneigten Facetten nur noch 0,5 µm breit.

Der epitaktische Aufwachsprozess begann horizontal im Graben in c-Richtung [0001] an der steileren Facette (79 Grad), da der Winkel zwischen c-Richtung und Oberflächennormale hier "nur" 11 Grad beträgt. Nach Erreichen der gegenüberliegenden Wand setzt sich das Wachstum vertikal bei seitlichem Überwachsen der Stege fort, wobei die Richtung im Galliumnitrid aufgrund einer 30-Grad Drehung nunmehr der {10-10}-Orientierung (m-Ebene) entspricht. Durch das seitliche Überwachsen der Stege wachsen die einzelnen Schichten schließlich zusammen.

Eine mit AFM (*Atomic Force Microscope*) gemessene Oberflächenrauhigkeit betrug 1,1 nm (Fläche 5 x 5 µm, RMS), die Kristallqualität wurde mit Röntgenmessung anhand der *Rocking Curve* zu einer Halbwertsbreite (FWHM, *Full Width Half Maximum*) von 500 Bogensekunden im Azimuth der <10-10>-Richtung bzw. von 650 Bogensekunden im Azimuth der <0001>-Richtung für die (10-10)-Oberfläche des Gitters bestimmt.

Die Bildung einer semipolaren GaN-Schicht wurde danach in Okada, N. et al.: "Growth of Se-mipolar (11-22) GaN Layer by Controlling Anisotropic Growh rates in r-plane Patterned Sapphire Substrate", Appi.Phys.Expr. 2 (2009), page 091001 beschrieben. "Semipolar" bedeutet hier einfach hinsichtlich der Polarität zwischen den möglichen Extremen der c-Ebene auf der einen Seite und der m- bzw. a-Ebene auf der anderen Seite liegend.

Durch geeignete Wahl der Prozessbedingungen beim MOVPE-Prozess konnte hier auf eine Maske auf den Stegen verzichtet werden. Die Oberseite des Stegs war entlang der r-Ebene (1-102) des Saphirsubstrats ausgerichtet, die seitlichen Facetten waren wiederum geneigt (etwa 32 Grad gegenüber der Horizontalen), diesmal jedoch war deren Normale parallel zur innerhalb des Saphirsubstrats geneigten c-Ebene orientiert, so dass einseitiges Wachstum in c-Richtung [0001] im Graben gewährleistet war. Die r-Ebene steht nicht senkrecht auf der c-Ebene. Durch die 30 Grad-Drehung um die c-Achse beim Aufwachsen auf Saphir kommt das Galliumnitrid-Kristallgitter mit der [11-22]-Richtung in vertikaler Richtung im Vergleich zur [1-102]-Richtung des Kristallgitters des Saphirsubstrats in gleiche Raumrichtung.

Hinsichtlich der Kristallqualität ergaben *Rocking Curve*-Messungen Halbwertsbreiten (FWHM) von 720 bzw. 319 Bogensekunden parallel und senkrecht zur c-Richtung für die (11-22)-Gitterebenen.

Begünstigt wurde das Wachstum besonders durch sehr ähnliche Winkel zwischen der r-Ebene und der c-Ebene beim Saphir und zwischen der (11-22)-Ebene und der c-Ebene beim Galliumnitrid.

Aus der Druckschrift US 7,220,324 B2 ist es bekannt, eine GaN-Schicht mit {10-11}-Orientierung auf einem {100}-Spinellsubstrat (MgAl₂O₄) aufzuwachsen. Das Spinellsubstrat ist dabei unstrukturiert, weil man die Methode der Bildung von Stegen und Gräben mit nachfolgendem zweistufigem Wachstum aufgrund der Facettenneigungen und der geringen Flächen für unzureichend und aufwendig hält.

Aus der Druckschrift US 7,645,688 B2 ist es bekannt, ein (11-23)-orientiertes Saphirsubstrat zu verwenden, um darauf eine in Richtung der m-Ebene (<10-10>-Richtung) orientierte unpolare Galliumnitridschicht aufzuwachsen. Das Substrat ist im Wesentlichen unstrukturiert. An sich würde man ein r-Ebenen Saphirsubstrat hernehmen, um unpolares (11-20)-, d.h. a-Ebenen-GaN aufwachsen zu lassen. Es wird nun dort aber vorgeschlagen, ein (11-23)-orientiertes Saphirsubstrat zu verwenden, weil die Gitterdimensionen in den beiden Ebenen (Saphir - GaN) zueinander passen und m-Ebenen-GaN stabiler sei als a-Ebenen-GaN.

Es besteht die Aufgabe, neue Wege bei der Herstellung von III-N-Einkristallen zu beschreiten und einen entsprechenden III-N-Einkristall mit semipolaren Eigenschaften bereitzustellen.

Die Aufgabe wird gelöst durch ein Verfahren mit den Merkmalen gemäß Anspruch 1 sowie durch ein Substrat mit aufgewachsener GaN-Schicht gemäß Anspruch 15 und durch ein freistehendes GaN-Substrat gemäß Anspruch 16. Vorteilhafte Ausgestaltungen ergeben sich aus den abhängigen Ansprüchen.

Dem erfindungsgemäßen Verfahren zufolge wird unter anderem vorgeschlagen, durch epitaktisches Aufwachsen ausgehend von einem in bestimmter Richtung orientierten Saphirsubstrat eine semipolare, {20-2*l*}-orientierte III-N-Schicht, insbesondere eine Galliumnitridschicht, zu erhalten. *l* repräsentiert hier eine natürliche Zahl, also *l* = 1, 2, 3, 4, ...Die hierbei gefundenen Ergebnisse hinsichtlich Oberflächenrauhigkeit und Kristallinität des fertigen Produkts sind überraschend nicht nur für bisher bekannte semipolar orientierte Galliumnitridschichten verbessert, sondern übertreffen auch semipolare oder unpolare, einkristalline GaN-Schichten anderer Orientierung.

Besonders gute Kristallinitäten wurden für die Kombination aus einem {11-23}-orientierten Saphirsubstrat mit einer darauf aufgewachsenen {10-11}-orientierten III-N-Schicht gefunden, also *l* = 2.

Alternativ können auch folgende Kombinationen von oberflächlichen Kristallorientierungen für Saphir und GaN verwendet werden: {20-21}-GaN auf {22-43}-Saphir d.h., *l* = 1) und {10-12}-GaN auf {11-26}-Saphir (d.h., *l* = 4). Abweichend von der oben angegebenen Familie von {20-2*l*} soll auch die Kombination aus {11-21}-GaN auf {10-11}-Saphir von der Erfindung umfasst sein. Es wurde gefunden, dass die Oberflächenrauhigkeit und Kristallinität des fertigen Produkts auch hier überraschend gut ausfallen. Das Verfahren ist für alle Kombinationen im Wesentlichen gleich.

Die III-N- bzw GaN-Schicht wächst "oberhalb" der Oberfläche des Saphirs. "Oberhalb" bezeichnet den sich entlang dem Normalenvektor auf der Saphiroberfläche erstreckenden Raum. Es können sich dabei auch Fremdschichten in diesen Raum teilweise zwischen dem Saphir und der III-N- bzw. GaN-Schicht befinden.

Bezogen auf den Saphir bezeichnet die "Oberfläche" eine vor jedweder Strukturierung (z.B. Bildung von Gräben etc.) vorhandene großflächige, oberflächliche Ebene (geschliffen, poliert, aufgewachsen etc.), zu welcher die angegebene Kristallebene parallel liegt. Kristallebene und kristallographische (Gitter-) Ebene werden hierin synonym verwendet und bezeichnen den gleichen Gegenstand.

Ausgestaltungen zufolge wird zur Herstellung die Bildung eines Grabens oder mehrerer Gräben im Saphirsubstrat vorgenommen. Die dabei gebildete seitliche Facette dient als Ausgangspunkt für ein Kristallwachstum zunächst in c-Richtung. Nach Erreichen der gegenüberliegende Facette oder dann, wenn benachbarte Streifen zu einer geschlossenen {10-11}-Ebene koaleszieren, also zusammengewachsen sind, setzt sich das Wachstum in <10-1 1>-richtung fort.

Es wurde herausgefunden, dass die Übereinstimmung der Winkel zwischen der <11-23>-Richtung und der c-Ebene beim Saphir und zwischen der <10-11>-Richtung und der c-Ebene beim Galliumnitrid ausreicht, das Kristallwachstum bei hoher Qualität zu gewährleisten.

Die Erfindung soll nun anhand von Ausfiihrungsbeispielen mit Hilfe einer Zeichnung detailliiert erläutert werden. Darin zeigen:
- Fig. 1:: eine Abfolge von Schritten zur Herstellung semipolaren {10-11}-Galliumnitrids anhand schematisch dargestellter Querschnittsprofile gemäß einem Ausführungsbeispiel der Erfindung;
- Fig. 2:: ein Pfeildiagramm mit räumlichen Orientierungen erfindungsgemäßer Kristallrichtungen in den Figuren 1 und 4;
- Fig. 3:: ein Diagramm mit einer Darstellung der durch Röntgenbeugung gemessenen *Rocking Curve* mit dem Reflex einer {11-23}-Ebene des Saphirsubstrats und dem Reflex einer {10-11}-Ebene der aufgewachsenen GaN-Schicht (ω-2θ-Scan) gemäß dem Beispiel aus Fig. 4;
- Fig. 4:: eine Rasterelektronenmikroskopaufnahme eines Querschnitts durch das Saphirsubstrat mit aufgewachsener GaN-Schicht gemäß dem weiteren Ausführungsbeispiel der Erfindung; und
- Fig. 5:: ein Photolumineszenzspektrum der beispielhaften GaN-Kristallschicht aus Fig. 4 gemäß der vorliegenden Erfindung.

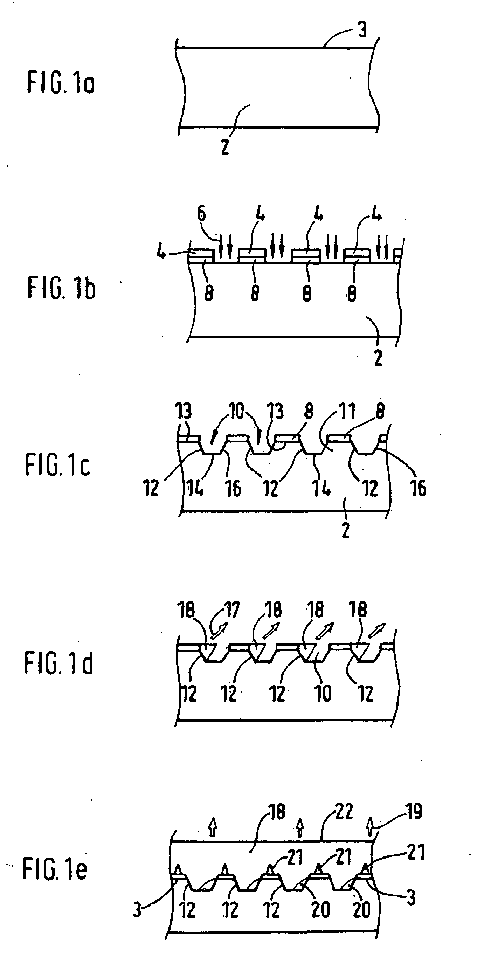

Ein Ausführungsbeispiel des erfindungsgemäßen Verfahrens zur Herstellung semipolaren Galliumnitrids ist in Fig. 1 dargestellt.

In einem ersten Schritt (Fig. 1a) wird ein ebener Wafer aus Saphir (Al₂O₃) bereitgestellt, der eine Oberfläche 3 besitzt, die einer Kristallebene der Orientierung {11-23} entspricht. Der Wafer dient als Startsubstrat 2 für das spätere Aufwachsen von Galliumnitrid. Solche Wafer sind kommerziell erhältlich, in dem konkreten Beispiel verwendet wurde ein 2"-Wafer mit einer Dicke von 430µm. Abwandlungen hinsichtlich Durchmesser und Dicke sind selbstverständlich möglich.

In einem zweiten Schritt (Fig. 1b) wird das Startsubstrat 2 lithografisch strukturiert. Dazu wird zunächt eine 200 nm dicke erste Maskierschicht 8 aus SiO₂ aufgebracht. Auf der SiO₂-Maske 8 wird ein Fotolack ("Photoresist") aufgebracht und mit üblichen Lithographieverfahren mit einem Streifenmuster versehen. Dann wird eine 550 nm dicke zweite Maskierschicht 4 aus Nickel und Gold aufgetragen. Anschließend wird der Photoresist entfernt (der Photoresist selbst ist in Fig. 1b nicht dargestellt, siehe aber Pfeile zu Bezugszeichen 6), wodurch nur die Bereiche der zweiten Nickel-Gold-Maskierschicht haften bleiben, die direkt auf der ersten Maskierschicht abgeschieden wurden, während die anderen Bereiche sich mit dem Photoresist ablösen ("Lift-Off"-Verfahren). Alternativ könnte auch die Ni-Au-Maske geätzt werden. Die Streifen erstrecken sich beispielsweise ganz über das Startsubstrat hinweg. Die Streifen verlaufen in der <10-10>-Richtung, die parallel zur Oberfläche liegt, sind parallel zueinander angeordnet und besitzen eine Breite von 3 µm. Die Öffnungen in der Gold-Nickelmaske sind ebenfalls 3 µm breit. Anschließend wird das Startsubstrat mit den beiden Maskierschichten einem reaktiven Ionenätzprozess (RIE, Bezugszeichen 4, oder auch ICP-RIE) oder einem anderen beliebigen, vorzugsweise trockenchemischen Ätzprozess ausgesetzt, welcher einen etwa 0,8-1,3 µm tiefen Graben 10 in den Saphirkristall ätzt. Die erste SiO₂-Maskierschicht wird dabei mit strukturiert und bleibt nur dort vorhanden, wo sie durch die Ni-Au-Maskierschicht geschützt ist.

Die dabei entstehenden Grabenwände 12, 16 besitzen beispielsweise eine Neigung von etwa 75 Grad. In dem ganz speziellen und in dieser Hinsicht nicht zu verallgemeinernden Beispiel wurde für den Ätzprozess eine Leistung von 300 W, eine Zuführung von Gasen aus BCl₃, Cl₂ und Ar im Verhältnis 2:2:1 und ein Druck von 20 mTorr verwendet.

Der ideale Winkel für die Grabenwände beträgt etwa 62°. In diesem Fall liegt die Ebene der Grabenwand parallel zur c-Ebene. Untersuchungen durch die Erfinder ergaben, dass Abweichungen von 15 oder sogar 20 Grad gegenüber jener Idealneigung völlig unkritisch für das spätere Wachstum von GaN sind. Solche "c-ähnlichen Facetten" sind von der Erfindung mitumfasst und der Neigungsgrad soll den Rahmen der Erfindung nicht einschränken. Der hier beschriebene Prozess funktioniert nämlich grundsätzlich, sobald ein Anwachsen in c-Richtung möglich ist.

Auf einer Seite bildet sich also eine Facette 12 aus, deren Oberfläche ungefähr parallel zur (0001)-Ebene (c-Ebene) des Saphirkristalls orientiert ist, so dass ein c-Wachstum einsetzen kann - auf der gegenüberliegend ausgebildeten Facette 16 dagegen nicht, weil die Abweichung von deren Neigung von der c-Orientierung des Saphirs zu groß ist. Zwischen den Streifen bzw. Gräben verbleiben Stege 11 im Saphirsubstrat. Diese Stege umfassen somit seitlich die geneigten Facetten sowie zwischen den Facetten die Oberseite, welche mit der ursprünglichen Oberfläche des Saphirs mit entsprechender Kristallausrichtung korrespondiert. Auf der Oberseite liegt dann die Maskierschicht aus SiO₂ auf.

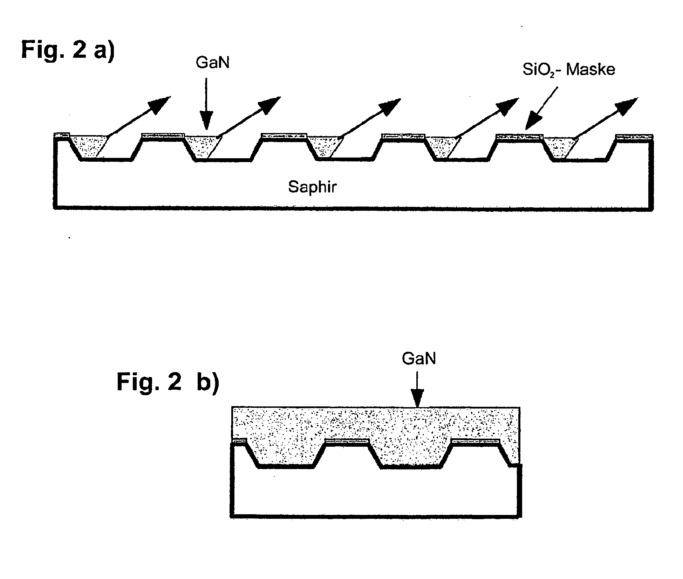

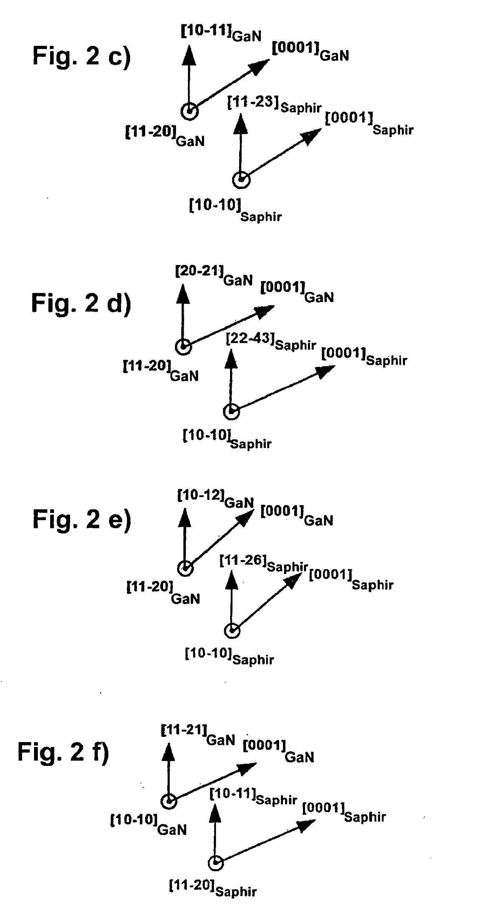

Ferner ist der lithografische Strukturierungsprozess so ausgelegt, dass die Streifen bzw. Gräben längs einer <10-10>-Richtung verlaufen (vgl. Fig. 2), also gemeinsam mit ihren Facetten 12 senkrecht zur m-Ebene des Saphirs (Al₂O₃) stehen. Der Normalenvektor der a-Ebene würde in den Figuren etwa nach links oben zeigen.

In dem beschriebenen Ausführungsbeispiel kommt die Schicht aus SiO₂ unter die Ni/Au-Maskierschicht und wird dann gemeinsam mit dem Saphir strukturiert. Es wäre alternativ aber auch denkbar, dass man die SiO₂-Maskierschicht nach dem Ätzen der Ni/Au-Maske aufbringt. Hierbei sind allerdings die Masken aufeinander auszurichten. Die Reihenfolge der Maskierung und die dabei verwendeten Materialien können durch die dem Fachmann geläufigen Alternativen in angemessener Weise abgewandelt werden.

Die verbleibenden Reste der Ni/Au-Maske werden nass-chemisch entfernt (z.B. 6 Teile H₂O, 2 Teile HCl und 1 Teil H₂O₂), die SiO₂-Maske verbleibt.

Das MOVPE-Wachstum beginnt mit dem Aufbringen einer sauerstoffdotierten Niedrigtemperatur-Nukleationsschicht (nicht in den Fig. dargestellt) aus Aluminiumnitrid (A1N).

Der Wachstumsprozess wird als metallorganische Gasphasenepitaxie (MOVPE) ausgeführt. Grundsätzlich kommen auch MBE, HVPE oder sonstige Epitaxieverfahren in Frage. MOVPE scheint aber für das selektive Wachstum besonders gut geeignet zu sein. Außerdem findet eine Nukleation auf Saphir optimal mit MOVPE statt. Die dem Fachmann geläufigen Alternativen, insbesondere die oben genannten, sind aber von dem hier vorgeschlagenen Verfahren grundsätzlich mit umfasst. In dem Beispiel wird ein Horizontalstromreaktor Aixtron-200/4 RF-S eingesetzt. Als Ausgangsstoffe werden Trimethylgallium (TMGa), Trimethylaluminium (TMAI) und hochreines Ammoniakgas (NH₃) verwendet. Als Trägergas kommt Wasserstoff, evt. vermischt mit Stickstoff, zum Einsatz. Die Prozesstemperatur wurde mittels eines Pyrometers auf der stromabwärtigen Seite der entsprechenden Substrathalterung geregelt. Insgesamt wurde in diesem Beispiel ungefähr 1 µm GaN bei einer Temperatur von 1130 Grad Celsius und einem Druck von 150 hPa aufgewachsen.

Unter diesen Bedingungen erfolgt das GaN-Wachstum ausgehend von der seitliche Facette 12, welche wie oben beschrieben genau oder ungefähr oder auch nur grob der c-Ebene des Saphirs 2 entspricht, d.h. in allen Gräben 10 nur einseitig. Auf der anderen Seite des Grabens kann es dabei zu einer geringfügigen parasitären Deposition von GaN kommen, jedoch mit einer deutlich geringeren Wachstumsrate. Das Wachstum auf der Oberseite des Stegs 11 wird durch die zweite Maskierschicht (SiO₂) unterbunden. Die Wachstumsrichtung entspricht der c-Richtung des Saphirs 2. Hier bildet sich auch die c-Richtung in der Kristallschicht 18 aus Galliumnitrid fort. Wie in dem ersten Unterschritt des schräg horizontalen Grabenwachstums 17 gemäß Fig. 1d zu erkennen ist, bildet sich eine Spitze im aufwachsenden Galliumnitrid aus, die sich dem jeweils gegenüberliegenden Steg 11 nähert.

Ist der gegenüberliegende GaN-Streifen erreicht, so beginnt ein im Wesentlichen vertikales Wachstum 19 über die Grabenoberkante hinaus als zweiter Unterschritt. Die Prozessbedingungen werden hier allerdings nicht geändert. Gleichwohl können auch jeweils angepasste Prozessbedingungen eingestellt werden, die ein verbessertes Wachstum ermöglichen. Es ist vorliegend nur noch Wachstum in vertikaler Richtung möglich.

Nach dem Zusammenwachsen benachbart aufgewachsener Kristallschichten 18 treten diese in Kontakt und bilden eine gemeinsame, durchgehende Oberfläche 22, wie in Fig. 1 e zu sehen ist. Zwischen der Kristallschicht 18 aus GaN und dem Startsubstrat 2 aus Saphir können an den gegenüberliegenden Grabenkanten bzw. Facetten 16 sog. voids (Leeräume) 20 auftreten, da das epitaktische Wachstum nicht notwendig den ganzen Graben 10 verfüllt. Gleiches gilt für einen Bereich zwischen den benachbart emporwachsenden Kristallschichten 18 unmittelbar auf der Stegoberseite 13 bzw. der Maskierschicht 8 (vgl. voids 21).

Fig. 2 zeigt noch einmal vereinfacht die beiden Unterschritte des Kristallwachstums zunächst in c-Richtung (Fig. 2a) und dann in <10-11>-Richtung (Fig. 2b). Fig. 2c zeigt die Kristallrichtungen jeweils im Saphir und im GaN bezogen auf die Darstellungen der Fig. 1a-e bzw. Fig. 2a-b, wobei neben der Herstellung des semipolaren {10-11}-GaN auch weitere Ausführungsformen der Erfindung beispielhaft dargestellt sind.

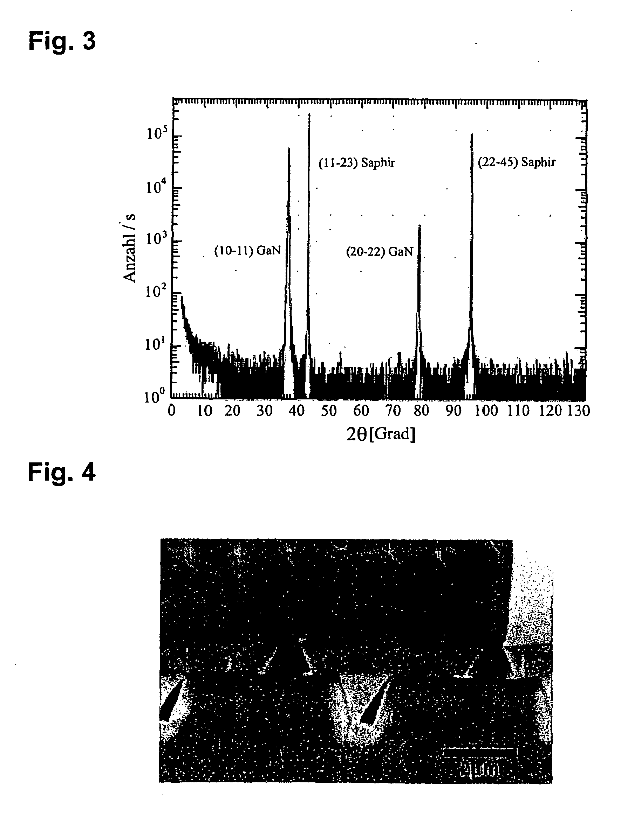

Fig. 4 zeigt eine Rasterelektronenmikroskopaufnahme eines Querschnitts durch das Saphirsubstrat 2 mit aufgewachsener GaN-Schicht 18 gemäß einem weiteren Ausführungsbeispiel der Erfindung. Im Unterschied zum ersten Beispiel beträgt die Breite der Stegoberseiten 13 etwa 4 µm und diejenige der Gräben lediglich 1,2 µm auf Höhe der Grabenoberkante bzw. 0,6 µm auf Höhe der Grundfläche 14 des Grabens. Die Aufnahme zeigt die Situation nach Aufwachsen von etwa 1 µm GaN. Die Kristallschichten 18 stehen kurz vor dem Zusammenwachsen und dem Bilden der gemeinsamen Oberfläche 22.

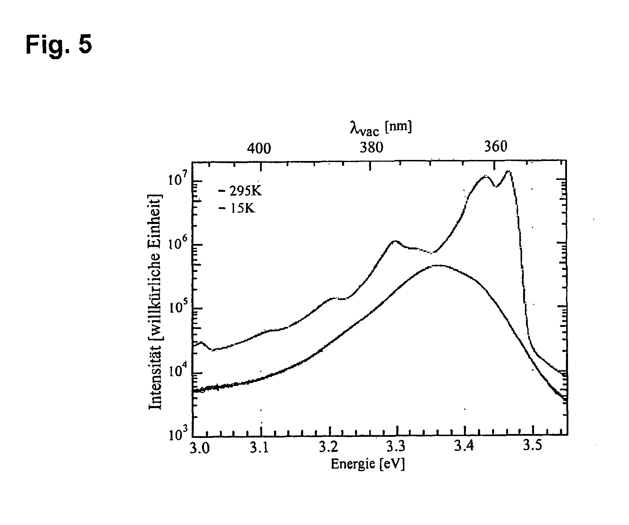

Die Testsubstrate (Saphir 2 mit aufgewachsenem GaN-Kristall 18) wurden in den Beispielen eingehender untersucht. Zur Quantifizierung der Kristallqualität wurden im Rahmen von Messungen der Röntgenbeugung (XRD) die sog. *Rocking Curve* (XRC) bestimmt und ω-2θ-Scans durchgeführt. Auch wurden Tieftemperatur-Photolumineszenzspektren (PL, bei 14 K) aufgenommen. Letztere lassen Rückschlüsse auf Defekte, insbesondere Stapelfehler in der Basalebene zu. Ein ω-2θ-Scan ist in Fig. 3 gezeigt, ein PL-Spektrum ist in Fig. 5 dargestellt.

In Fig. 3 kann aus dem ω-2θ-Scan insbesondere die (10-11)-Ausrichtung der aufgewachsenen Kristallschicht 18 aus GaN verifiziert werden. In Fig. 3 ist deutlich zu erkennen, dass lediglich Peaks auftreten, die entweder der {11-23}-Familie des Saphirs (Al₂O₃), also des Ausgangssubstrats 2, oder der {10-11}-Familie des Galliumnitrids (GaN) 18 zuzuordnen sind.

Die entsprechende Messung der *Rocking Curve* (XRC) liefert Halbwertsbreiten (FWHM: *full width at half maximum*) von weniger als 400 Bogensekunden sowohl für die symmetrische (10-11)-Reflexion als auch für die asymmetrischen (0002)- bzw. (10-12)-Reflexionen. Die Halbwertsbreiten geben Aufschluss über die Kristallqualität. 400 Bogensekunden repräsentieren derzeit relativ gute Werte für Material in einer Nicht-c-Orientierung. Die einzeln angegebenen Reflexe geben an, was genau gemessen wurde, und sind notwendig, um die gemessene Breite richtig zu interpretieren. Manche Reflexe fallen prinzipiell schmäler aus und manche breiter.

Bei einer Röntgenmessung hängen die gemessenen Halbwertsbreiten z.B. der *Rocking Curve* grundsätzlich von der verwendeten Röntgenstrahlung ab. Im Bereich der Halbleiterkristalle bzw. Epitaxie wird aber insbesondere für die hoch-auflösende Röntgendiffraktometrie (XRD) generell die Cu Kα-Strahlung verwendet. Der jeweils verwendete Anodenkörper der Röntgenröhre umfasst Kupfer. Die hier angegebenen Werte beziehen sich auf diese Cu Kα-Strahlung.

Fig. 5 zeigt das Ergebnis der Photolumineszenz-(PL)-Spektren, aufgenommen bei 15 K (obere Kurve) und bei 295 K (untere Kurve). Deutlich sichtbar wird eine bandkantennahe Emission (NBE: *near-band-edge-emission*) bei 3,464 eV. In semi-oder unpolar auf Saphir aufgewachsenen GaN-Kristallen ist diese Lumineszenz für gewöhnlich wenig ausgeprägt, während dort die Lumineszenz von Defekten dominiert. Gleichwohl sind auch in Fig. 5 solche auf Defekte zurückzuführende Peaks - beispielsweise bei 3,43 eV oder bei 3,30 eV - zu erkennen, die auf Stapelfehler zurückzuführen sind.

Für die Bestimmung der Rauhigkeit der erhaltenen (10-11)- Oberfläche wurden Messungen mit dem Rasterkraftmiskroskop (AFM: *Atomic Force Microscope*) durchgeführt. Auf einer Fläche von 3 µm x 3 µm wurde eine Rauheit von weniger als 0,3 nm (mittlere quadratische Abweichung, root mean square RMS), auf einer Fläche 1 µm x 1 µm eine Rauheit von sogar weniger als 0,1 nm (RMS) gemessen.

Die vorbeschriebenen Beispiele zeigen Untersuchungen an bis zu 1 µm aufgewachsenen GaN-Kristallschichten 18. Weitere hier nicht näher beschriebene Ausführungsbeispiele beziehen sich auf die Fortbildung zu weitaus dickeren, zusammengewachsenen GaN-Schichten 18, aus denen vollständige Substrate für die Verwendung beim Bau optoelektronischer Bauelemente oder solcher für die Sensorik, Hochfrequenzanwendungen etc. gebildet werden können. Solche Substrate, die die oben beschriebenen Eigenschaften hinsichtlich Kristallinität und Oberflächengüte besitzen, erweisen sich dabei in der Bauelementeherstellung als besonders vorteilhaft.

Vom Schutzumfang sind daher Kombinationen von Startsubstraten 2 mit darauf aufgewachsenen Kristallschichten 18 sowie auch bereits davon abgelöste, großflächige III-N- bzw. GaN-Kristallschichten umfasst. Durchmesser von 2" oder 4" oder mehr sind durchaus realistisch. Eine Grenze für den Durchmesser ist durch die Erfindung nicht gesetzt.

Mit MOVPE lassen sich derzeit nur moderate Wachstumsraten von etwa 2µm/h erzielen. In diesem Fall wird vorzugsweise zunächt ein Saphir-Wafer strukturiert, die GaN-Schicht dann mit MOVPE angewachsen und nach einigen µm die Schicht für das Bauelement abgeschieden.

Um deutlich dickere Schichten ("bulk"-Material) zu erhalten, kann vorteilhaft auch HVPE eingesetzt werden (Wachstumsrate: 100µm/h und mehr). In diesem Fall kann man einige mm bis zu einigen cm abscheiden. Danach schneidet man diesen Kristall bzw. "Boule" in einzelne Wafer mit z.B. identischer Orientierung und wächst die Bauelementschichten anschließend mit MOVPE oder MBE in entsprechenden Reaktoren auf die resultierenden Wafer auf.

Soweit das Anwachsen von GaN mit HVPE auf Saphir prozesstechnische Probleme aufwerfen könnte, könnte als Variante zunächst auch eine dünne MOVPE-Schicht wie beschrieben abgeschieden werden, wonach der Wafer dann in einen HVPE-Prozess (HVPE-Reaktor) überführt wird um einen vergleichsweise dickeren Kristall aufzuwachsen.

Ferner wurden im vorbeschriebenen Verfahren detaillierte Angaben über Prozessbedingungen (Temperatur; Druck; Vorläufergase; Ätzverfahren; Epitaxieverfahren; Anzahl der Prozessschritte; Materialien für Maskier- oder Nukleationsschichten, Schichtdicken, Grabenbreiten etc.) gemacht. Dem Fachmann wird aber sofort ersichtlich, dass auch Modifikationen oder Abweichungen davon möglich sind, so wie sie auch bei der Herstellung von GaN anderer bekannter Kristallausrichtungen geläufig sind.

Hinsichtlich der Maskierschichten kommen so beispielsweise auch SiN oder Al₂O₃ etc. in Frage. In Bezug auf Nukleationsschichten kann auf reichliche Literatur verwiesen werden, beispielsweise auf Kuhn, B. et al., in Phys. Status Solidi A.188, p.629, 2001, oder Hertkorn, J. et al in J. Cryst. Growth 308, p.30, 2007 im Fall von Niedertemperatur-Nukleationsschichten, auf die das vorliegende Verfahre nicht beschränkt sein soll.

Hinsichtlich der Temperaturen im Reaktor besteht eine Abhängigkeit unter anderem auch von dessen Typ, so dass die oben angegebenen Werte für das spezielle Ausführungsbeispiel gelten. Auch für den angegebenen Typ kann von den Temperaturen durchaus abgewichen werden. Als MOVPE-Reaktor oder HVPE-Reaktor kommt jeder gängige Typ in Betracht, welcher III-N-Kristalle aufwachsen kann.

Entsprechende Überlegungen betreffen nicht nur die beispielhafte Kombination von Ausgangs- und aufgewachsenem Kristall wie oben beschrieben, Vielmehr betreffen sie auch Abwandlung mit folgenden Kombinationen von oberflächlichen Kristallorientierungen für Saphir und GaN: {2-201}-GaN auf {22-43 }-Saphir, {10-12}-GaN auf {11-26}-Saphir sowie auch {11-21}-GaN auf {10-11}-Saphir.

## Patentansprüche

1. Verfahren zur Herstellung eines ein Gruppe-III-Nitrid (III-N) umfassenden, semipolaren Halbleiterkristalls, mit den Schritten:
Vorbereiten eines Saphir (Al₂O₃) umfassenden Startsubstrats (2) mit einer ersten Oberfläche (3), die zu einer Kristallebene des Saphirs parallel ist, unter Bildung wenigstens eines. Grabens (10) in der ersten Oberfläche (3);
Epitaktisches Aufwachsen (17, 19) einer semipolaren Kristallschicht (18) umfassend das Gruppe-III-Nitrid (III-N) auf dem Startsubstrat (2) oberhalb der ersten Oberfläche (3) unter Bildung einer zweiten Oberfläche (22), die zu der ersten Oberfläche (3) im Wesentlichen parallel ist und durch eine Kristallebene in dem Gruppe-III-Nitrid gebildet wird,
wobei die erste Oberfläche (3) des Startsubstrats (2)
(a) durch eine Kristallebene der Familie {11-23} des Saphirs gebildet wird, und die zweite Oberfläche (22) durch eine Kristallebene der Familie {10-11} in dem Gruppe-III-Nitrid gebildet wird, oder
(b) durch eine Kristallebene der Familie {22-43} des Saphirs gebildet wird, und die zweite Oberfläche (22) durch eine Kristallebene der Familie {20-21} in dem Gruppe-III-Nitrid gebildet wird, oder
(c) durch eine Kristallebene der Familie {11-26} des Saphirs gebildet wird, und die zweite Oberfläche (22) durch eine Kristallebene der Familie {10-12} in dem Gruppe-III-Nitrid gebildet wird, oder
(d) durch eine Kristallebene der Familie {10-11} des Saphirs gebildet wird, und wobei die zweite Oberfläche (22) durch eine Kristallebene der Familie {11-21} in dem Gruppe-III-Nitrid gebildet wird.

2. Verfahren gemäß Anspruch 1, wobei der Graben (10) entlang der <10-10>-Richtung im Kristallgitter des Saphirs (Al₂O₃) gebildet wird.

3. Verfahren gemäß Anspruch 1 oder 2, wobei der Graben (10) eine seitliche Facette (12) mit einer Neigung aufweist, und wobei sich die seitliche Facette (12) parallel zu einer Kristallebene der Familie {0001}in dem Saphir (Al₂O₃) erstreckt, oder gegen diese um gleich oder weniger als 25 Grad geneigt ist.

4. Verfahren gemäß Anspruch 3, wobei die seitliche Facette (12) gegen die Kristallebene der Familie {0001 }in dem Saphir (Al₂O₃) um gleich oder weniger als 15 Grad geneigt ist.

5. Verfahren gemäß einem der Ansprüche 3 bis 4,
wobei mehrere Gräben (10) mit jeweils einem dazwischen liegenden, die Gräben (10) trennenden Steg (11) ausgebildet werden, wobei der trennende Steg (11) über seine Länge hinweg eine Oberseite (13) und an deren beiden Längsseiten angrenzend jeweils eine seitlich geneigte Facette (12, 16) aufweist,
von denen die eine Facette (12) parallel zu der c-Kristallebene der Familie {0001} in dem Saphir (Al₂O₃) orientiert oder gegen diese um gleich oder weniger als 25 Grad bzw. 15 Grad geneigt ist.

6. Verfahren gemäß einem der Ansprüche 3 bis 5, wobei der oder die Gräben (10) mit den seitlichen Facetten (12, 16) durch Bilden wenigstens einer Maskierschicht (4) und anschließendem Ätzen (6) des Saphir (Al₂O₃) umfassenden Startsubstrats (2) in vorab strukturierten Öffnungen in der wenigstens einen Maskierschicht (4) ausgebildet werden.

7. Verfahren gemäß den Ansprüchen 5 und 6, wobei die wenigstens eine Maskierschicht (4) oder eine mit der Maskierschicht (4) strukturierte weitere Maskierschicht (8) auf der Oberseite (13) des Stegs (11) außerhalb der Gräben verbleibt und vorzugsweise aus Siliziumdioxid (SiO₂) oder Siliziumnitrid (SiN) gebildet ist, wobei die Maskierschicht (8) eingerichtet ist, ein Wachstum (17, 19) des Gruppe-III-Nitrids auf der Oberseite (13) des Stegs (11) zu reduzieren oder ganz zu verhindern.

8. Verfahren gemäß einem der Ansprüche 3 bis 7, wobei der Schritt des epitaktischen Aufwachsens des Gruppe-III-Nitrids einen ersten Unterschritt (17) des seitlichen Aufwachsens auf der bzw. auf den seitlichen Facette(n) (12) in dem Graben (10) bzw. in den Gräben (10) in einer Richtung senkrecht zur Kristallebene der Familie {0001} des Saphirs (Al₂O₃) umfasst.

9. Verfahren gemäß Anspruch 8, wobei der Schritt des epitaktischen Aufwachsens des Gruppe-III-Nitrids einen sich an den ersten Unterschritt anschließenden zweiten Unterschritt des Aufwachsens umfasst, in welchem das weitere Wachstum im Wesentlichen in einer Richtung senkrecht zur Kristallebene der Familie {11-23} bzw. {22-43} bzw. {10-11} bzw. {11-26} des Saphirs (Al₂O₃) stattfindet.

10. Verfahren gemäß einem der Ansprüche 1 bis 9, wobei der oder die Gräben (10) mit einer Breite und einer Tiefe ausgebildet werden, wobei die Breite und die Tiefe um maximal einen Multiplikationsfaktor 10 auseinander liegen.

11. Verfahren gemäß einem der Ansprüche 5 bis 10, wobei der oder die Gräben (10) und Stege (11) ein paralleles Streifenmuster bilden.

12. Verfahren gemäß einem der Ansprüche 5 bis 11, wobei im zweiten Unterschritt das Wachstum in der Richtung senkrecht zur Kristallebene der Familie {11-23} bzw. {22-43} bzw. {10-11} bzw. {11-26} des Saphirs (Al₂O₃) von einem seitlich lateralen Überwachsen der die Gräben trennenden Stege begleitet wird, so dass abhängig von der Stegbreite ein Zusammenwachsen der aus benachbarten Gräben herauswachsenden Kristallschichten unter Bildung einer gemeinsamen, geschlossenen Oberfläche des Gruppe-III-Nitrids (III-N) stattfindet.

13. Verfahren gemäß einem der vorstehenden Ansprüche,
wobei für das Gruppe-III-Nitrid (III-N) im Wesentlichen Galliumnitrid (GaN), Indiumgalliumnitrid (GaInN) oder Aluminiumgalliumnitrid (AlGaN) oder AlGaInN verwendet wird. oder
bei dem das Aufwachsen (17, 19) anhand eines Metall-Organischen Gasphasenepitaxie-Prozesses (MOVPE) oder Hydrid-Gasphasenepitaxie-Prozesses (HVPE) durchgeführt wird, oder
ferner umfassend den Schritt des Abtrennens der aufgewachsenen semipolaren Kristallschicht von dem Startsubstrat (2).

14. Verfahren gemäß einem der Ansprüche 5 bis 13,
wobei nach dem Ausbilden der Gräben (10) und den diese trennenden Stegen (11) und vor dem Aufwachsen eine Nukleationsschicht, vorzugsweise umfassend AlN oder GaN, auf das Startsubstrat (2) aufgebracht wird

15. Ein Substrat umfassend Saphir (Al₂O₃) mit einer darauf aufgewachsenen semipolaren Kristallschicht (18) umfassend Galliumnitrid (GaN), Aluminiumgalliumnitrid (AlGaN), Indiumgalliumnitrid (InGaN), oder Aluminiumgalliumindiumnitrid (AlGaInN), mit einer ebenen Oberfläche entsprechend einer Kristallrichtung der Familie {10-11} oder {20-21} oder {10-12}, oder entsprechend einer Kristallrichtung der Familie {11-21}, wobei sich die Oberfläche des Saphirs jeweils in entsprechender Zuordnung parallel zu einer Kristallrichtung der Familie {11-23} bzw. {22-43 bzw. {11-26 bzw. {10-11} erstreckt.

16. Freistehendes einkristallines, semipolares Substrat umfassend Galliumnitrid (GaN), Aluminiumgalliumnitrid (AlGaN), Indiumgalliumnitrid (InGaN), oder Aluminiumgalliumindiumnitrid (AlGaInN), mit einer ebenen Oberfläche entsprechend einer Kristallrichtung der Familie {20-2*l*}, wobei *l* eine natürliche Zahl mit 1=1,2 oder 4 repräsentiert, oder entsprechend einer Kristallrichtung der Familie {11-21}, wobei die Oberfläche des freistehenden Substrats
- Kantenlängen von wenigstens 5cm x 5cm oder eine Diagonale von 5cm besitzt, und
- eine gemäß einem homogenen Epitaxieprozess ausgebildete Oberflächenrauhigkeit aufweist.

17. Freistehendes einkristallines, semipolares Substrat gemäß Anspruch 16, wobei die Oberflächenrauhigkeit - bestimmt mit einem AFM auf Flächen von 3µm x 3µm - weniger als 2,0 nm (RMS) beträgt.

18. Freistehendes einkristallines, semipolares Substrat gemäß Anspruch 16 oder 17, wobei die Oberflächenrauhigkeit weniger als 1,0 nm (RMS) oder weniger als 0,3 nm (RMS) beträgt.

19. Freistehendes einkristallines, semipolares Substrat nach einem der Ansprüche 16 bis 18,
wobei hinsichtlich der Kristallinität eine Messung der Rocking-Curve in Bezug auf die Ebenen des {10-11}-Kristallgitters eine entsprechende Halbwertsbreite von weniger als 1000 Bogensekunden, vorzugsweise von weniger als 400 Bogensekunden liefert, oder wobei hinsichtlich der Kristallinität eine Messung der Rocking-Curve in Bezug auf die Ebenen des {10-11}-Kristallgitters eine entsprechende Halbwertsbreite von weniger als 100 Bogensekunden liefert.

20. Verwendung eines Verfahrens nach einem der Ansprüche 1-14 oder des Substrats nach Anspruch 14 oder des freistehenden, einkristallinen, semipolaren Substrats nach einem der Ansprüche 15-18 zur Herstellung eines elektronischen Bauteils oder eines optoelektronischen Elements.

## Claims

1. Method of manufacturing a semipolar semiconductor crystal comprising a group-III-nitride (III-N), including the steps:
preparing a start substrate (2) comprising sapphire (Al₂O₃) and having a first surface (3) parallel to a crystallographic plane of the sapphire, wherein at least one trench (10) is formed in the first surface (3);
epitactically growing (17, 19) a semipolar crystal layer (18) comprising the group-III-nitride (III-N) on the start substrate (2) above the first surface (3) thereby forming a second surface (22), which is substantially parallel to the first surface (3) and is formed by a crystallographic plane of the group-III-nitride,
wherein the first surface (3) of the start substrate (2)
(a) is formed by a crystallographic plane of the family {11-23} of sapphire, and the second surface (22) is formed by a crystallographic plane of the family {10-11} in the group-III-nitride, or
(b) is formed by a crystallographic plane of the family {22-43} of sapphire, and the second surface (22) is formed by a crystallographic plane of the family {20-21} in the group-III-nitride, or
(c) is formed by a crystallographic plane of the family {11-26} of sapphire, and the second surface (22) is formed by a crystallographic plane of the family {10-12} in the group-III-nitride, or
(d) is formed by a crystallographic plane of the family {10-11} of sapphire, and the second surface (22) is formed by a crystallographic plane of the family {11-21} in the group-III-nitride.

2. The method of claim 1, wherein the trench (10) is formed along a <10-10>-direction in the crystal grid of the sapphire (Al₂O₃).

3. The method of claim 1 or 2, wherein the trench (10) is formed with a lateral facet (12) having an inclination, and wherein the lateral facet (12) extends parallel with respect to a crystallographic plane of the family {0001}in the sapphire (Al₂O₃), or is inclined with respect to the same by 25 degrees or less.

4. The method of claim 3, wherein the lateral facet (12) is inclined with respect to the crystallographic plane of the family {0001} in the sapphire (Al₂O₃) by 15 degrees or less.

5. The method of one of claims 3 through 4,
wherein multiple trenches (10) are formed in conjunction with a web (11) each positioned between and separating two of the trenches (10), wherein the separating web (11) has along its length a top face (13) and adjacent both of its lateral sides each a lateral, inclined facet (12, 16),
one facet (12) of the lateral inclined facets being oriented parallel to the c-crystallographic plane of the family {0001} in the sapphire (Al₂O₃), or inclined with respect to the same by 25 degrees, or 15 degrees, respectively.

6. The method of one of claims 3 through 5, wherein the one or more trenches (10) having the lateral facets (12, 16) is/are formed by forming at least one mask layer (4) and subsequently etching (6) the start substrate (2) comprising the sapphire (Al₂O₃) in previously structured openings within the at least one mask layer (4).

7. The method of one of claims 5 and 6, wherein the at least one mask layer (4) or a further mask layer (8) structured in conjunction with the mask layer (4) remains on the top face (13) of the web (11) outside of the trenches and is preferably made from silicon dioxide (SiO₂) or silicon nitride (SiN), wherein the mask layer (8) is configured to reduce a growth (17, 19) of the group-III-nitride on the top face (13) of the web (11), or to completely inhibit the same.

8. The method of one of claims 3 through 7, wherein the step of epitactically growing the group-III-nitride includes a first sub-step (17) of laterally growing the group-III-nitride on the lateral facet(s) (12) within the trench(es) (10) in a direction perpendicular to the crystallographic plane of the family {0001} of the sapphire (Al₂O₃).

9. The method of claim 8, wherein the step of epitactically growing the group-III-nitride includes a second sub-step of growing growing the group-III-nitride, in which the further growth is performed substantially in a direction perpendicular to the crystallographic plane of the family {11-23} or {22-43 or {10-11} or {11-26} of the sapphire (Al₂O₃), respectively.

10. The method of one of claims 1 through 9, wherein the one or more trench(es) (10) is/are formed with a width and a depth, wherein the width and the depth differ by a multiplication factor of 10 at maximum.

11. The method of one of claims 5 through 10, wherein the one or more trench(es) (10) and web(s) (11) form a parallel stripe pattern.

12. The method of one of claims 5 through 11, wherein in the second sub-step the growth in the direction perpendicular to the crystallographic plane of the family {11-23} or {22-43} or {10-11} or {11-26} of the sapphire (Al₂O₃), respectively, is accompanyied by a lateral overgrowth over the webs separating the trenches, such that depending on the width of the web(s) a merging of crystal layers growing out from neighbouring trenches is performed under formation of a common continuous surface of the group-III-nitride (III-N).

13. The method of one of the preceding claims,
wherein substantially one of gallium nitride (GaN), indium gallium nitride (GaInN) or aluminium gallium nitride (AlGaN), or AIGaInN, is used for the group-III-nitride (III-N), or
wherein the growth (17, 19) is performed by means of a metal-organic vapour phase epitaxy-process (MOVPE) or a hydride vapor phase epitaxy-process (HVPE), or
further comprising the step of removing the grown semipolar crystal layer from the start substrate (2).

14. The method of one of claims 5 through 13,
wherein after the formation of the trenches (10) and the webs (11) separating the same and before the process of growing a nucleation layer, preferably comprising AIN or GaN, is formed on the start substrate (2).

15. A substrate comprising sapphire (Al₂O₃) and a semipolar crystal layer (18) grown thereupon and comprising gallium nitride (GaN), aluminium gallium nitride (AlGaN), or indium gallium nitride (InGaN), or aluminium gallium indium nitride (AlGaInN) having a plane surface according to a crystal direction of the family {10-11} or {20-21} or {10-12}, or according to a crystal direction of the family {11-21}, wherein the surface of the sapphire extends in corresponding association parallel to a crystal direction of the family {11-23} or {22-43} or {11-26} or {10-11}, respectively.

16. Freestanding monocrystalline, semipolar substrate comprising gallium nitride (GaN), aluminium gallium nitride (AlGaN), or indium gallium nitride (InGaN), or aluminium gallium indium nitride (AlGaInN) having a plane surface according to a crystal direction of the family {20-2*l*}, wherein *l* represents a natural number, preferably 1, 2 or 4, or according to a crystal direction of the family {11-21}, wherein the surface of the freestanding substrate includes
- lengths of its edges of at least 5 cm x 5 cm or a length of its diagonal von 5 cm, and
- a surface roughness that is consistent with a homogenous epitaxy process.

17. Freestanding monocrystalline, semipolar substrate according to claim 16, wherein the surface roughness - determined using an atomic force microscope on areas sized to 3µm x 3µm - amounts to less than 2.0 nm (RMS).

18. Freestanding monocrystalline, semipolar substrate according to claim 16 or 17, wherein the surface roughness amounts to less than 1.0 nm (RMS) or less than 0.3nm (RMS).

19. Freestanding monocrystalline, semipolar substrate according to claim 16 through 18,
wherein with regard to crystal quality a measurement of a Rocking Curve with respect to planes of the {10-11}-crystal grid yields a corresponding full width at half maximum (FWHM) of less than 1000 arc seconds, preferably less than 400 arc seconds, or wherein with regard to crystal quality a measurement of a Rocking Curve with respect to planes of the {10-11}- grid yields a corresponding full width at half maximum (FWHM) of less than 100 arc seconds.

20. Use of the method according to one of claims 1 through 14 or of the substrate according to claim 14 or of the freestanding monocrystalline semipolar substrate according to claims 15 through 18 for manufacturing an electronic component or an optoelectronic element.

## Revendications

1. Procédé de production d'un cristal semi-conducteur semipolaire présentant un nitrure de classe III (N-III), comprenant les étapes consistant à :
préparer un substrat de départ (2) comprenant du saphir (Al₂O₃) avec une première surface (3) qui est parallèle à un plan cristallin du saphir, en formant au moins une tranchée (10) dans la première surface (3) ;
procéder à la croissance épitaxiale (17, 19) d'une couche de cristal semipolaire (18) comprenant le nitrure de classe III (N-III) sur le substrat de départ (2) au-dessus de la première surface (3), en formant une deuxième surface (22) qui est essentiellement parallèle à la première surface (3) et est formée dans le nitrure de classe III par le biais d'un plan cristallin,
dans lequel la première surface (3) du substrat de départ (2)
(a) est formée par un plan cristallin de la famille {11-23} du saphir et la deuxième surface (22) est formée par un plan cristallin de la famille {10-11} dans le nitrure de classe III, ou
(b) est formée par un plan cristallin de la famille {22-43} du saphir et la deuxième surface (22) est formée par un plan cristallin de la famille {20-21} dans le nitrure de classe III, ou
(c) est formée par un plan cristallin de la famille {11-26} du saphir et la deuxième surface (22) est formée par un plan cristallin de la famille {10-12} dans le nitrure de classe III, ou
(d) est formée par un plan cristallin de la famille {10-11} du saphir et la deuxième surface (22) est formée par un plan cristallin de la famille {11-21} dans le nitrure de classe III.

2. Procédé selon la revendication 1, dans lequel la tranchée (10) est formée le long de l'orientation <10-10> dans le réseau cristallin du saphir (Al₂O₃).

3. Procédé selon la revendication 1 ou 2, dans lequel la tranchée (10) présente une facette latérale (12) ayant une inclinaison et dans lequel la facette latérale (12) s'étend parallèlement à un plan cristallin de la famille {0001} dans le saphir (Al₂O₃), ou est inclinée en direction de celui-ci à un angle égal ou inférieur à 25 degrés.

4. Procédé selon la revendication 3, dans lequel la facette latérale (12) est inclinée en direction du plan cristallin de la famille {0001} dans le saphir (Al₂O₃) à un angle égal ou inférieur à 15 degrés.

5. Procédé selon l'une des revendications 3 à 4, dans lequel plusieurs tranchées (10) sont aménagées avec respectivement une âme (11) séparant les tranchées (10) situées entre celles-ci, dans lequel l'âme séparatrice (11) présente, sur toute sa longueur, une face supérieure (13) et, sur ses deux faces longitudinales, respectivement adjacents à une facette inclinée latéralement (12, 16),
dont l'une des facettes (12) est orientée parallèlement au plan cristallin c de la famille {0001} dans le saphir (Al₂O₃) ou est inclinée en direction de celui-ci selon un angle égal ou inférieur à 25 degrés ou 15 degrés.

6. Procédé selon l'une des revendications 3 à 5, dans lequel la ou les tranchées (10) sont aménagées avec les facettes latérales (12, 16) dans des ouvertures préalablement structurées dans la au moins une couche de masque (4) par formation d'au moins une couche de masque (4) et gravure consécutive (6) du substrat de départ (2) comprenant du saphir (Al₂O₃).

7. Procédé selon les revendications 5 et 6, dans lequel la au moins une couche de masque (4) ou une autre couche de masque (8) structurée avec la couche de masque (4) reste sur la face supérieure (13) de l'âme (11) en dehors des tranchées et est formée de préférence à partir de dioxyde de silicium (SiO₂) ou de nitrure de silicium (SiN), la couche de masque (8) étant mise en place afin de réduire ou d'inhiber totalement une croissance (17, 19) du nitrure de classe III sur la face supérieure (13) de l'âme (11).

8. Procédé selon l'une des revendications 3 à 7, dans lequel l'étape de croissance épitaxiale du nitrure de classe III comprend une première sous-étape (17) de croissance latérale sur la ou les facettes latérales (12) dans la tranchée (10) ou dans les tranchées (10) dans une direction perpendiculaire au plan cristallin de la famille {0001} du saphir (Al₂O₃).

9. Procédé selon la revendication 8, dans lequel l'étape de croissance épitaxiale du nitrure de classe III comprend une deuxième sous-étape de croissance s'adjoignant à la première sous-étape, dans laquelle la deuxième croissance a lieu essentiellement dans une direction perpendiculaire au plan cristallin de la famille {11-23} et/ou {22-43} et/ou {10-11} et/ou {11-26} du saphir (Al₂O₃).

10. Procédé selon l'une des revendications 1 à 9, dans lequel la ou les tranchées (10) sont aménagées avec une largeur et une profondeur, la largeur et la profondeur étant différentes d'un facteur multiplicateur de 10 au maximum.

11. Procédé selon l'une des revendications 5 à 10, dans lequel la ou les tranchées (10) et les âmes (11) forment un motif strié parallèle.

12. Procédé selon l'une des revendications 5 à 11, dans lequel, dans la deuxième sous-étape, la croissance dans la direction perpendiculaire au plan cristallin de la famille {11-23} et/ou {22-43} et/ou {10-11} et/ou {11-26} du saphir (Al₂O₃) est accompagnée par une surcroissance latérale des âmes séparant les tranchées de sorte que, indépendamment de la largeur d'âme, une croissance conjointe des couches de cristaux croissant hors des tranchées voisines a lieu en formant une surface commune fermée du nitrure de classe III (N-III).

13. Procédé selon l'une des revendications précédentes, dans lequel on utilise pour le nitrure de classe III (N-III) essentiellement du nitrure de gallium (GaN), du nitrure d'indium - gallium (GalnN) ou du nitrure d'aluminium - gallium (AlGaN) ou de l'AlGaInN ou
dans lequel la croissance (17, 19) est réalisée à l'aide d'un procédé d'épitaxie en phase gazeuse métallo-organique (MOVPE) ou procédé d'épitaxie en phase gazeuse d'hydrure (HVPE), ou
lequel comprend en outre l'étape consistant à séparer du substrat de départ (2) la couche de cristal semipolaire ayant effectué sa croissance.

14. Procédé selon l'une des revendications 5 à 13, dans lequel, après la formation des tranchées (10) et des âmes les séparant (11) et avant la croissance, une couche de nucléation, comprenant de préférence de l'AIN ou du GaN, est déposée sur le substrat de départ (2).

15. Substrat comprenant du saphir (Al₂O₃) avec une couche de cristal semipolaire (18) ayant effectué sa croissance par-dessus, comprenant du nitrure de gallium (GaN), du nitrure d'aluminium - gallium (AlGaN), du nitrure d'indium - gallium (InGaN) ou du nitrure d'aluminium - gallium - indium (AlGainN), avec une surface plane correspondant à une orientation du cristal de la famille {10-11} ou {20-21} ou {10-12} ou correspondant à une orientation du cristal de la famille {11-21}, la surface du saphir s'étendant respectivement en ordre correspondant parallèlement à une orientation du cristal de la famille {11-23} et/ou {22-43} ou {11-26} ou {10-11}.

16. Substrat semipolaire monocristallin détaché, comprenant du nitrure de gallium (GaN), du nitrure d'aluminium - gallium (AlGaN), du nitrure d'indium - gallium (InGaN) ou du nitrure d'aluminium - gallium - indium (AlGalnN), avec une surface plane correspondant à une orientation du cristal de la famille {20-2*l*}, *l* représentant un nombre naturel avec l = 1, 2 ou 4, ou correspondant à une orientation du cristal de la famille {11-21}, la surface du substrat dégagé
- possédant des longueurs d'arête d'au moins 5 x 5 cm ou une diagonale de 5 cm, et
- présentant une rugosité de surface formée selon un procédé d'épitaxie homogène.

17. Substrat semipolaire monocristallin détaché selon la revendication 16, dans lequel la rugosité de surface - déterminée par AFM sur des surfaces de 3 µm x 3 µm - est inférieure à 2,0 nm (RMS).

18. Substrat semipolaire monocristallin détaché selon la revendication 16 ou 17, dans lequel la rugosité de surface est inférieure à 1,0 nm (RMS) ou inférieure à 0,3 nm (RMS).

19. Substrat semipolaire monocristallin détaché selon l'une des revendications 16 à 18, dans lequel, en matière de cristallinité, une mesure en bercement par rapport aux plans du réseau cristallin {10-11} donne une demi-largeur correspondante inférieure à 1000 secondes d'arc, de préférence inférieure à 400 secondes d'arc, ou dans lequel, en matière de cristallinité, une mesure en bercement par rapport aux plans du réseau cristallin {10-11} donne une demi-largeur correspondante inférieure à 100 secondes d'arc,

20. Utilisation d'un procédé selon l'une des revendications 1 à 14 ou du substrat selon la revendication 14 ou du substrat semipolaire monocristallin détaché selon l'une des revendications 15 à 18 pour la production d'un composant électronique ou d'un élément opto-électronique.
